# EUROPEAN PATENT APPLICATION

(11) **EP 2 410 566 A1**
(43) Date of publication of application: **25.01.2012**
(21) Application number: 10290259.0
(22) Date of filing: 22.07.2010
(51) Int. Cl.: H01L 27/02

(54) **An integrated circuit, comprising ESD circuitry for protecting a terminal of the integrated circuit**

(71) Applicant: NXP B.V., 5656 AG Eindhoven (NL)
(72) Inventor: Bouvier, Stephane, Caen Cedex 9 (FR)
(74) Representative: Schouten, Marcus Maria

(57) **Abstract**

There is disclosed an integrated circuit (IC1; IC2; IC3) comprising a terminal (TML) for inputting or outputting signals from the integrated circuit, and a first ESD diode (D5; D8) connected to the terminal for protecting the terminal against ESD events. The integrated circuit further comprises a voltage buffer circuit (V_Buff) that is connected in parallel with the first ESD diode for maintaining a constant voltage across the first ESD diode.

## Description

The present invention relates to an integrated circuit, the integrated circuit having circuitry for protecting a terminal of the integrated circuit from ESD (electrostatic discharge) events.

An ESD event typically comprises an unwanted external charge flowing into or out of the exposed terminals of an integrated circuit, though close contact with other charged objects. Such events can involve large voltage potentials reaching several thousand volts, and can cause considerable damage to the integrated circuit. ESD events can be classified as positive or negative; positive events involving positive ESD voltages and negative events involving negative ESD voltages.

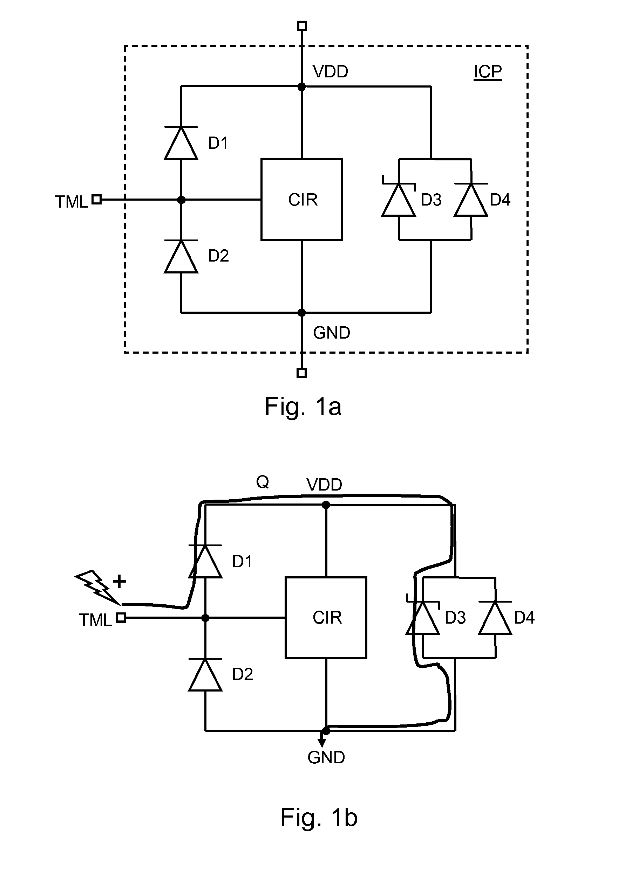

Fig.1a shows a known integrated circuit ICP comprising a circuit CIR that is protected by ESD diodes ED1, ED2, ED3, and ED4. The biasing of the diodes means that they do not conduct under usual operating conditions, but that can conduct to help dissipate energy to the positive and negative voltage supplies VDD and GND during an ESD event. The diode ED3 is a breakdown diode, meaning that it will break down and conduct in reverse bias once the voltage across it reaches a large enough level. This level is obviously larger than the level of VDD.

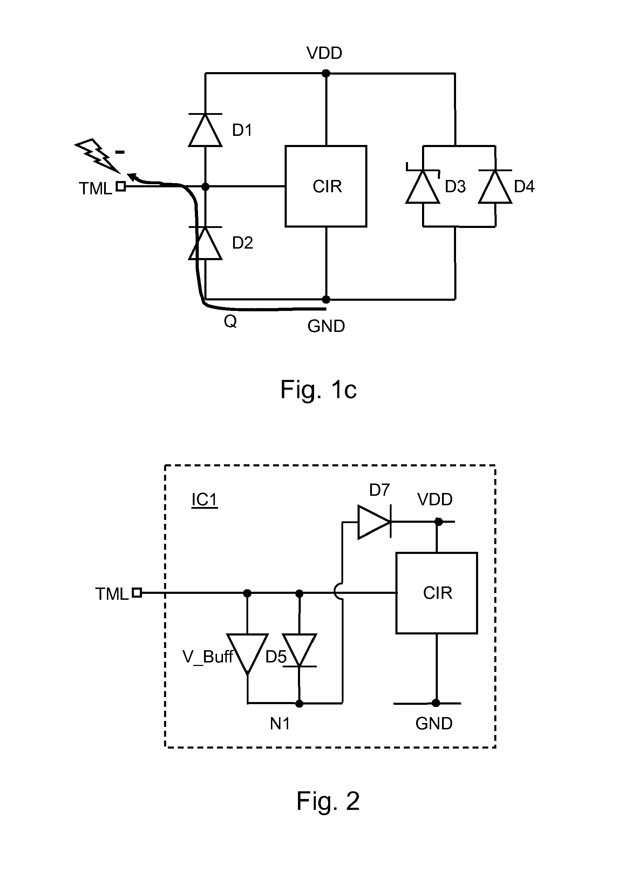

The integrated circuit ICP has a terminal TML for inputting/outputting signals to the circuit CIR, and Fig.1b shows the flow of charge Q when the terminal TML is subjected to a positive ESD event, whereas Fig.1c shows the flow of charge Q when the terminal TML is subjected to a negative ESD event.

Under normal circuit operating conditions, the ESD diodes are reverse biased, meaning they have a high ohmic resistance and primarily behave as capacitors. The value of an ESD diode's capacitance depends on the voltage level that is applied across the diode. This means that the capacitances of the ESD diodes ED1 and ED2 of Fig.1 will vary according to the signal level that is applied to the terminal TML. These variable capacitances can cause distortions to the signal level of the terminal TML. ESD diodes are each typically formed by several transistors, and common configurations known in the art are CROWBAR's, BIGFET's etc. Examples of these types of circuits are described in US 2004080880 and US 2009089719 respectively.

To give effective ESD protection, ESD diodes need to have a low resistance during ESD events so that they can quickly dissipate the energy from the ESD event before too much damage to the circuit occurs. Therefore, to improve ESD protection it is advantageous to use large ESD diodes, or in other words ESD diodes formed from transistors that have a larger physical area and therefore have a lower resistance.

However, the larger the ESD diodes, the larger their capacitances, and the more distortion the ESD diodes can cause to circuit signals.

The signal distortion is particularly problematic in circuits where accurate analog voltage signals are required.

According to an embodiment of the invention, there is provided an integrated circuit comprising:
- a terminal for inputting or outputting signals from the integrated circuit, and;
- a first ESD diode connected to the terminal for protecting the terminal against ESD events;
wherein the integrated circuit further comprises a voltage buffer circuit that is connected in parallel with the first ESD diode for maintaining a constant voltage across the first ESD diode.

Since the first ESD diode is connected in parallel with a voltage buffer circuit, the potential difference across the diode is kept substantially constant, for example close to or at 0V. Keeping the potential difference across the diode at a substantially constant level means that the capacitance of the diode remains substantially constant, and so all signal levels that are applied to the terminal see the same level of ESD diode capacitance, reducing distortion.

Advantageously, embodiments of the invention may be implemented in Analog to Digital converters, wherein the terminal receiving the analog input voltage has a voltage buffer in parallel with the ESD diode protecting the terminal. Then, the substantially constant ESD diode capacitance results in reduced distortion of the analog input voltage.

Furthermore, embodiments of the invention may be implemented in Digital to Analog converters, wherein the terminal outputting the analog output voltage has a voltage buffer in parallel with the ESD diode protecting the terminal. Then, the substantially constant ESD diode capacitance results in reduced distortion of the analog output voltage.

The integrated circuit may further comprise a second ESD diode also connected in parallel with the voltage buffer, the first ESD diode and the second ESD diode being biased opposite to one another for protecting the terminal against both positive and negative ESD events.

The first, or the first and the second ESD diodes may be connected in series with a further ESD diode, the further ESD diode being connected to a power supply to help dissipate energy from ESD events. For example, the further ESD diode may be an additional ESD diode, or a breakdown ESD diode, as described in the embodiments hereinafter.

Embodiments of the invention will be apparent from and further elucidated by the following figures and examples, which are not intended to limit the scope of the invention. The person skilled in the art will understand that various embodiments may be combined.
Fig. 1 a shows a schematic diagram of a known integrated circuit;
Fig. 1b shows the flow of charge within the integrated circuit of Fig.1a during a positive ESD event;
Fig. 1c shows the flow of charge within the integrated circuit of Fig.1a during a positive ESD event;
Fig. 2 shows a schematic diagram of an integrated circuit according to an embodiment of the invention;
Fig. 3 shows a schematic diagram of an integrated circuit according to a second embodiment of the invention; and
Fig. 4 shows a schematic diagram of an integrated circuit according to a third embodiment of the invention.

Fig.2 shows an integrated circuit IC1 according to a first embodiment of the invention. The integrated circuit has a terminal TML for inputting or outputting signals from a circuit CIR, and an ESD diode D5 that is connected to the terminal TML. The ESD diode D5 is connected in parallel with a voltage buffer circuit V_Buff for keeping the voltage across the ESD diode D5 at a substantially constant level. For example, if a signal that rises from 1 V to 2V is applied to terminal TML, then the output of the voltage buffer will drive the node N1 from 1V to 2V, constantly maintaining the voltage across the ESD diode D5 at approximately 0V. Since the voltage across the ESD diode D5 remains substantially constant, the capacitance presented to the terminal TML by the ESD diode D5 also remains substantially constant, and so distortion of the signal applied to the terminal TML is minimized.

The voltage buffer circuit may have an offset voltage, such that the output voltage is always offset from the input voltage, providing that the voltage buffer still maintains a substantially constant potential difference across the diode over a range of different terminal TML voltages.

A voltage buffer is a common type of circuit that is known to those skilled in the art, and so no further explanations are given here.

During a positive ESD strike to the terminal TML, the excess charge can flow from terminal TML and through ESD diode D5. In this embodiment, a additional ESD diode D7 connects the node N1 to the positive voltage supply VDD for dissipating the excess charge, although other arrangements are possible as will become apparent from the further embodiments described herein.

One variation to Fig.2 would be to bias the diode D5 in the opposite direction, to protect against negative ESD strikes to the terminal TML instead of positive strikes. Then, the additional ESD diode D7 could be connected from node N1 to the negative voltage supply GND, and biased from the negative supply voltage to node N1.

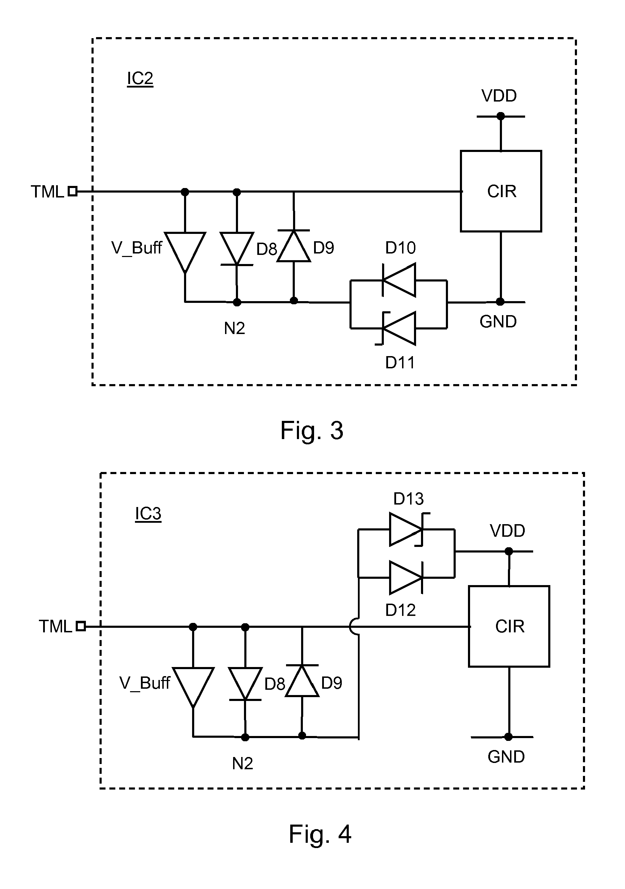

Fig.3 shows an integrated circuit IC2 according to a second embodiment of the invention. The integrated circuit IC2 comprises first and second ESD diodes D8 and D9, which are both connected in parallel with the voltage buffer V_Buff, and which are biased in opposite directions to one another for protecting against both positive and negative ESD events at the terminal TML.

There is an additional ESD diode D10 connected in series with the first ESD diode D8, and to the negative voltage supply GND. The additional ESD diode D10 is biased from the negative voltage supply to the first ESD diode D8 for protecting the terminal TML against negative ESD events.

There is a breakdown ESD diode D11 connected in series with the first ESD diode D8, and to the negative voltage supply GND. The breakdown ESD diode D11 is biased from the negative voltage supply to the first ESD diode D8 for protecting the terminal TML against positive ESD events.

During a positive ESD event at the terminal TML, excess charge flows from the terminal TML, through the first ESD diode D8, and through the breakdown ESD diode D11 to the negative voltage supply GND.

During a negative ESD event at the terminal TML, excess charge flows from the negative supply terminal GND, through the additional diode D10, and through the second diode D9 to the terminal TML.

In normal operation, the voltage buffer V_Buff maintains the voltage across the ESD diodes D8 and D9 at a substantially constant level, so that the ESD diodes D8 and D9 present a substantially constant capacitance to the terminal TML.

In a third embodiment shown in Fig.4, an additional ESD diode D12 is connected to the positive voltage supply VDD, and biased from the first ESD diode to the positive voltage supply for protecting the terminal against positive ESD events. Furthermore, a breakdown diode D13 is connected to the positive voltage supply VDD and biased from the first ESD diode to the positive voltage supply for protecting the terminal against negative ESD events.

During a positive ESD event at the terminal TML, excess charge flows from the terminal TML, through the first ESD diode D8, and through the additional ESD diode D12 to the positive voltage supply VDD.

During a negative ESD event at the terminal TML, excess charge flows from the positive supply terminal GND, through the breakdown diode D13, and through the second diode D9 to the terminal TML.

A fourth embodiment (not shown in the Figs) comprises both the additional ESD diode 10 of the second embodiment and the additional ESD diode 12 of the third embodiment, so that additional diodes for protecting against both positive and negative ESD events are present. The fourth embodiment further comprises both the breakdown ESD diode D11 of the second embodiment and the breakdown ESD diode D13 of the third embodiment, so that breakdown diodes for protecting against both positive and negative ESD events are present. Further combinations will be apparent to those skilled in the art without departing from the scope of the appended claims.

The circuit CIR of the first to fourth embodiments may be any circuit having a terminal TML for inputting or outputting signals. For example, the circuit CIR may be an Analog to Digital converter with the terminal TML being used to input an analog voltage, or the circuit CIR may be a Digital to Analog converter with the terminal TML being used to output an analog voltage.

## Claims

1. An integrated circuit (IC1; IC2; IC3) comprising:
- a terminal (TML) for inputting or outputting signals from the integrated circuit, and;
- a first ESD diode (D5; D8) connected to the terminal for protecting the terminal against ESD events;
wherein the integrated circuit further comprises a voltage buffer circuit (V_Buff) that is connected in parallel with the first ESD diode for maintaining a constant voltage across the first ESD diode.

2. The integrated circuit of claim 1, further comprising a second ESD diode (D9) also connected in parallel with the voltage buffer, the first ESD diode (D8) and the second ESD diode (D9) being biased opposite to one another for protecting the terminal against both positive and negative ESD events.

3. The integrated circuit of claims 1 or 2, further comprising an additional ESD diode (D7; D10; D12) connected in series with the first ESD diode.

4. The integrated circuit of claim 3, wherein the additional ESD diode (D7; D12) is connected to a positive voltage supply (VDD) and is biased from the first ESD diode to the positive voltage supply for protecting the terminal against positive ESD events.

5. The integrated circuit of claim 3, wherein the additional ESD diode (D7; D10) is connected to a negative voltage supply (GND) and is biased from the negative voltage supply to the first ESD diode for protecting the terminal against negative ESD events.

6. The integrated circuit of any preceding claim, further comprising a breakdown ESD diode (D11; D13) connected in series with the first ESD diode.

7. The integrated circuit of claim 6, wherein the breakdown ESD diode (D13) is connected to a positive voltage supply and is biased from the first ESD diode to the positive voltage supply for protecting the terminal against negative ESD events.

8. The integrated circuit of claim 7, wherein the breakdown ESD diode (D11) is connected to a negative voltage supply and is biased from the negative voltage supply to the first ESD diode for protecting the terminal against positive ESD events.

9. The integrated circuit of any preceding claim, wherein the integrated circuit comprises an analog to digital converter (CIR), and wherein the terminal is for inputting an analog voltage to be converted into a digital value.

10. The integrated circuit of any of claims 1 to 8, wherein the integrated circuit comprises a digital to analog converter (CIR), and wherein the terminal is for outputting an analog voltage converted from a digital value.
